# EUROPEAN PATENT APPLICATION

(11) **EP 2 105 953 A1**
(43) Date of publication of application: **30.09.2009**
(21) Application number: 07832893.7
(22) Date of filing: 30.11.2007
(51) Int. Cl.: H01L 21/314, C23C 16/26, H01L 21/31, H01L 21/768, H01L 23/522

(54) **AMORPHOUS CARBON FILM, SEMICONDUCTOR DEVICE, FILM FORMING METHOD, FILM FORMING APPARATUS AND STORAGE MEDIUM**

(30) Priority: 01.12.2006 JP 2006326172
(71) Applicant: Tokyo Electron Limited, Tokyo 107-8481 (JP)
(72) Inventor: KIKUCHI, Yoshiyuki, Hillsboro, OR 97124 (US); KOBAYASHI, Yasuo, Nirasaki-shi Yamanashi 407-0192 (JP); KAWAMURA, Kohei, Nirasaki-shi Yamanashi 407-0192 (JP); NOZAWA, Toshihisa, Amagasaki-shi Hyogo 660-0891 (JP); ISHIKAWA, Hiraku, Sendai-shi Miyagi 981-3131 (JP)
(74) Representative: Manitz, Finsterwald & Partner GbR
(86) International application number: PCT/JP2007/073228
(87) International publication number: WO 2008/066173

(57) **Abstract**

Provided is an amorphous carbon film having a high elastic modulus and a low thermal contraction rate with a suppressed low dielectric constant, a semiconductor device including the amorphous carbon film and a technology for forming the amorphous carbon film. Since the amorphous carbon film is formed by controlling an additive amount of Si (silicon) during film formation, it is possible to form the amorphous carbon film having a high elastic modulus and a low thermal contraction rate with a suppressed dielectric constant as low as 3.3 or less. Accordingly, when the amorphous carbon film is used as a film in the semiconductor device, troubles such as a film peeling can be suppressed.

## Description

### [Technical Field]

The present invention relates to an amorphous carbon film used in, e.g., a semiconductor device and a technology of forming the amorphous carbon film.

### [Background Art]

In a process for manufacturing a semiconductor device, there is performed a damascene process in which a recess portion is formed in an interlayer insulating film made of a low dielectric constant, called as low-k, material such as a CF film (fluorine-containing carbon film) or a SiCOH film (film containing silicon, oxygen, carbon, and hydrogen) and then a wiring made of Cu (copper) is formed in such a recess portion. In the damascene process, formed between the Cu wiring and the interlayer insulating film is a barrier film for suppressing a diffusion of the Cu into the interlayer insulating film. The barrier film has been made of, e.g., SiCN (silicon carbon nitride) made up mainly of silicon and having Si atomic ratio of 50% or more therein, for example. However, in order to achieve a high-speed operation of the semiconductor device, it has been considered to improve electric conductivity of wiring and lower a dielectric constant of the interlayer insulating film, and in addition to this, it is highly required to lower a dielectric constant of the barrier film.

For this reason, it has been considered to use an insulating film made of amorphous carbon made up mainly of carbon and hydrogen instead of the SiCN as the barrier film. The amorphous carbon has advantages in that it has a high barrier property against a metal such as Cu and has a high adhesivity with each material constituting the interlayer insulating film as described above and a metal such as Cu.

In the process for manufacturing the semiconductor device, it is desirable that a film has a high elastic modulus since there is an instance where a stress is applied to the film. However, the amorphous carbon is disadvantageous in that an elastic modulus thereof is low. Further, the semiconductor device is exposed to an atmospheric atmosphere after various kinds of films and wirings for constituting the device are formed, and then it is annealed at a temperature of, e.g., about 400°C in, e.g., a N₂ gas atmosphere. However, since the amorphous carbon has a high thermal contraction rate, a film thickness thereof can be reduced by, e.g., about 6% by such an annealing process. Accordingly, there is a likelihood that an amorphous carbon film used as a barrier film is peeled off from an interlayer insulating film or a wiring metal or disconnects a wiring during a manufacturing process. For this reason, it is difficult to employ the amorphous carbon film in the semiconductor device although it has the above-stated advantages.

For example, in case of using the amorphous carbon film as the barrier film as described above, if a reduction ratio of the film thickness, a so-called film thickness reduction, is high, the amorphous carbon film is peeled off from the wiring and the interlayer insulating film, resulting in a deterioration of Cu wiring conductivity.

### [Disclosure of the Invention]

An object of the present invention is to provide an amorphous carbon film having a high elastic modulus and a low thermal contraction rate with a suppressed low dielectric constant, a semiconductor device including the amorphous carbon film and a technology of forming the amorphous carbon film.

In accordance with the present invention, there is provided an amorphous carbon film, which contains hydrogen and carbon, is formed with an additive silicon and has a dielectric constant of about 3.3 or less.

In accordance with the present invention, there is provided an amorphous carbon film, which may be formed by exciting a hydrocarbon gas having a multiple bond and a silicon-containing gas into plasma.

In accordance with the present invention, there is provided a semiconductor device including: multilayer wiring circuits, each having a wiring metal and an interlayer insulating film; and an amorphous carbon film interleaved between the wiring circuits, and the amorphous carbon film contains hydrogen and carbon, is formed with an additive silicon and has a dielectric constant of about 3.3 or less.

In accordance with the present invention, the amorphous carbon film may be used as a barrier film for preventing an element of a wiring metal in one wiring circuit from being diffused into an interlayer insulating film of an adjacent wiring circuit.

In accordance with the present invention, the amorphous carbon film may be layered on the interlayer insulating film and used as a mask when forming a recess portion, in which a wiring metal is buried, in the interlayer insulating film.

In accordance with the present invention, there is provided a film forming method including: mounting a substrate on a mounting table installed in a processing chamber; and forming an insulating film including silicon-containing amorphous carbon on the substrate by plasma obtained by exciting a hydrocarbon gas having a multiple bond and a silicon-containing gas into plasma within the processing chamber.

In accordance with the present invention, the hydrocarbon gas may be a butyne gas.

In accordance with the present invention, an internal pressure of the processing chamber may be maintained in a range from about 5.33 Pa to about 9.33 Pa during formation of the insulating film.

In accordance with the present invention, there is provided a film forming apparatus including: a processing chamber; a mounting table installed in the processing chamber, for mounting a substrate; a gas evacuation unit for evacuating an inside of the processing chamber; a first gas supply unit for supplying a plasma generation gas to the inside of the processing chamber; a second gas supply unit for supplying a hydrocarbon gas having a multiple bond and a silicon-containing gas to the inside of the processing chamber; and a plasma generator for forming an insulating film including silicon-containing amorphous carbon on the substrate by plasma obtained by exciting the hydrocarbon gas and the silicon-containing gas into plasma within the processing chamber.

In accordance with the present invention, there is provided a storage medium storing a computer program for performing a film forming method on a computer, the film forming method including: mounting a substrate on a mounting table installed within a processing chamber; and forming an insulating film made of silicon-containing amorphous carbon on the substrate by plasma obtained by exciting a hydrocarbon gas having a multiple bond and a silicon-containing gas into plasma within the processing chamber.

In accordance with the present invention, since the amorphous carbon film is formed while controlling an additive amount of Si (silicon) during film formation, it is possible to obtain the amorphous carbon film having a high elastic modulus and a low thermal contraction rate with a dielectric constant suppressed as low as 3.3 or less. Therefore, troubles such as film peeling can be suppressed when the amorphous carbon film is used as a film in the semiconductor device. As a result, it is possible to make use of its advantageous properties such as a low dielectric constant and a barrier property against a metal, e.g., Cu.

### [Brief Description of the Drawings]

Figs. 1(a) to 1(f) provide process drawings showing a manufacturing sequence of a semiconductor device including an amorphous carbon film of the present invention;
Fig. 2 is a longitudinal cross-sectional side view showing an example of a film forming apparatus for forming the amorphous carbon film;
Fig. 3 is a plane view of a gas supply unit to be installed in the film forming apparatus;
Fig. 4 is a perspective view of an antenna unit to be installed in the film forming apparatus;
Figs. 5(a) to 5(h) provide process drawings showing a manufacturing sequence of another semiconductor device including an amorphous carbon film of the present invention;
Fig. 6 is a schematic plane view illustrating an example of a semiconductor manufacturing apparatus for manufacturing the semiconductor device;
Figs. 7(a) to 7(f) provide process drawings showing a manufacturing sequence of a still another semiconductor device including an amorphous carbon film of the present invention;
Fig. 8 is a configuration view of a substrate processing system including a semiconductor manufacturing apparatus in accordance with an embodiment of the present invention;
Fig. 9 is a longitudinal cross-sectional side view of the still another semiconductor device including the amorphous carbon film of the present invention;
Figs. 10(a) and 10(b) are graphs showing a result of an evaluation test on a relationship among a thermal contraction rate and a dielectric constant of the film and a flow rate of a film forming gas;
Figs. 11(a) and 11(b) are graphs showing a result of an evaluation test on a relationship among a thermal contraction rate and a dielectric constant of the film and a flow rate of a film forming gas;
Fig. 12 is a graph showing a relationship between strength of an electric field applied onto the film and a leakage current density of the film;
Fig. 13 is a characteristic graph showing characteristics of an amorphous carbon film of the present invention;
Figs. 14(a) to 14(d) provide schematic diagrams showing cross sections of the film and an amorphous carbon film not containing Si;
Fig. 15 is a graph showing a measurement result of Young's modulus of each of the films;
Fig. 16 is a graph showing a measurement result of a hardness of each of the films;
Figs. 17(a) and 17(b) provide infrared spectrums of each of the films;
Fig. 18 is a graph showing a measurement result of a stress of each of the films;
Figs. 19(a) to 19(c) are cross-sectional views illustrating a change in the amorphous carbon film of the present invention between before and after an annealing process;
Figs. 20(a) to 20(c) are cross-sectional views illustrating a change in the amorphous carbon film of the present invention between before and after an annealing process; and
Fig. 21 is a graph showing effects of a pressure during film formation on a thermal contraction rate and a dielectric constant.

### [Best Mode for Carrying out the Invention]

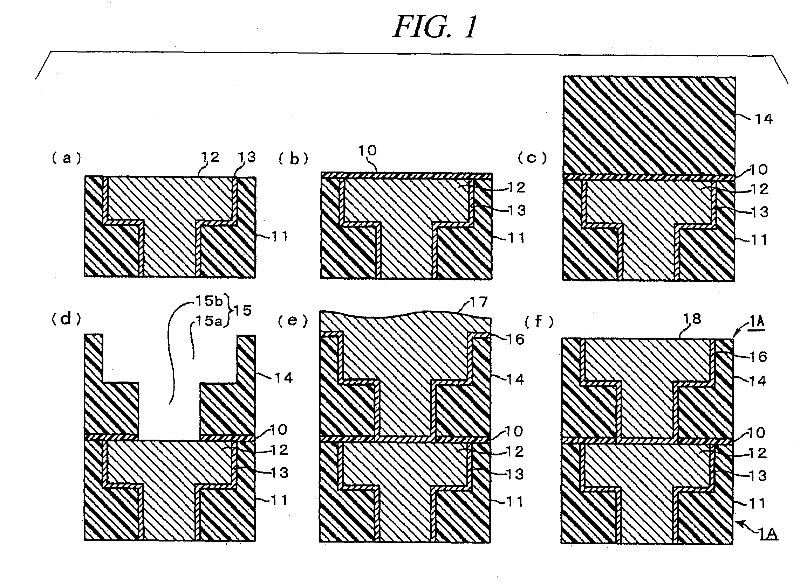

Fig. 1 illustrates an embodiment of a semiconductor device employing an amorphous carbon film of the present invention. The semiconductor device of the embodiment has a multilayer interconnection structure in which the amorphous carbon film of the present invention is employed as a barrier film interleaved between an interlayer insulating film of an n^{th} wiring circuit and an interlayer insulating film of an (n+1)^{th} wiring circuit. Fig. 1 illustrates a process for forming the wiring circuit.

Fig. 1(a) illustrates a part of the n^{th} wiring circuit 1A. A reference numeral 11 denotes an interlayer insulating film made up of, e.g., a SiCOH film. A reference numeral 12 denotes a Cu (copper) wiring and a reference numeral 13 denotes a barrier metal in a recess portion. Further, as the barrier metal 13, a layered film made of, e.g., Ta (tantalum) and Ti (titanium) can be used. In the process of forming the wiring circuit 1A, the wiring circuit 1A is formed by layering the interlayer insulating film 11, the barrier metal 13 and the Cu wiring 12 in sequence. Subsequently, as illustrated in Fig. 1(b), the amorphous carbon film 10 of the present invention is formed so as to cover the interlayer insulating film 11 and the wiring 12, and then as illustrated in Fig. 1(c), layered on the amorphous carbon film 10 is an interlayer insulating film 14 made of, e.g., SiCOH.

Formed in the interlayer insulating film 14 is a recess portion 15 including a trench 15a in which a wiring is formed and a hole 15b serving as a via hole. The wiring 12 is exposed in the recess portion 15 (Fig. 1(d)). Thereafter, formed on a surface of the recess portion 15 is a conductive barrier metal 16 which is the layered film made of Ta and Ti, for example. Subsequently, after a Cu metal 17 is buried in the recess portion 15 (Fig. 1(e)), the redundant Cu metal 17 and the barrier metal 16 formed on the surface of the interlayer insulating film 14 are removed by CMP (Chemical Mechanical Polishing), and a wiring 18 electrically connected with the wiring 12 is formed, whereby the wiring circuit 1A in an upper layer is formed (Fig. 1(f)).

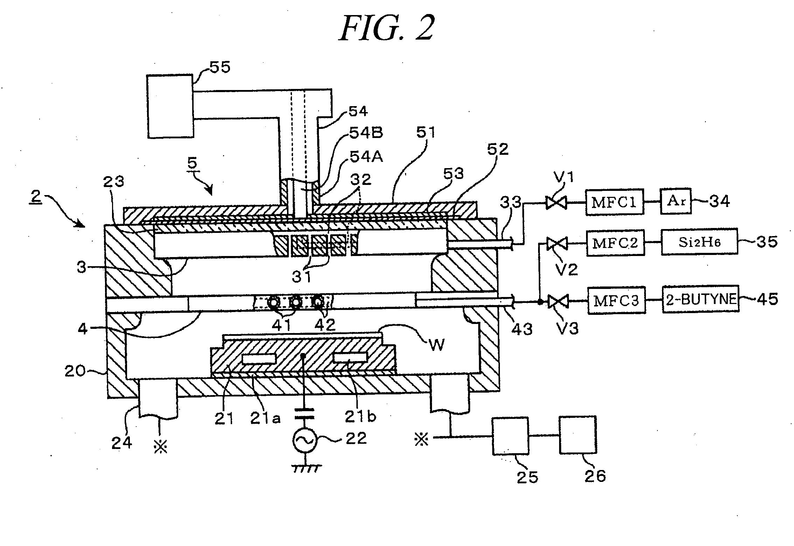

Hereinafter, a plasma film forming apparatus 2 for exciting 2-butyne (C₄H₆) and Si₂H₆ (disilane) as a hydrocarbon gas having a multiple bond into plasma and forming the above-stated amorphous carbon film 10 will be briefly explained with reference to Figs. 2 to 4. The plasma film forming apparatus 2 is a CVD (Chemical Vapor Deposition) apparatus for generating plasma by using a radial line slot antenna. A reference numeral 20 in the drawing denotes a cylinder-shaped processing chamber 20 (vacuum chamber) as a whole, a side wall or a bottom portion of the processing chamber 20 is made of a conductor such as aluminum-containing stainless steel or the like, and formed on an inner wall surface thereof is a protective film made of aluminum oxide.

A mounting table 21 serving as a mounting unit for mounting a substrate, e.g., a silicon wafer W thereon is provided on a substantially central portion of the processing chamber 20 with an insulating member 21a therebetween. The mounting table 21 is made of, e.g., aluminum nitride (AlN) or aluminum oxide (Al₂O₃) and provided within the mounting table 21 are a cooling jacket 21b for flowing a coolant and a non-illustrated heater constituting a temperature control unit together with the cooling jacket 21b. A mounting surface of the mounting table 21 is used as an electrostatic chuck and also serves as a lower electrode for plasma generation.

A ceiling portion of the processing chamber 20 is opened and installed at this portion is a first gas supply unit 3, which has, e.g., a plane shape of a substantially circle, facing the mounting table 21 via a sealing member (not illustrated) such as an O-ring. The gas supply unit 3 is made of, e.g., aluminum oxide and a gas flow path 32 communicated with an end of gas supply holes 31 is formed in the surface facing the mounting table 21 and the gas flow path 32 is connected with an end of a first gas supply channel 33. Meanwhile, the other end of the first gas supply channel 33 is connected with a rare gas supply source 34 for supplying a plasma generation gas (plasma gas) such as an argon (Ar) gas or a krypton (Kr) gas, which is supplied into the gas flow path 32 via the first gas supply channel 33 and then uniformly supplied into a space below the first gas supply unit 3 via the gas supply holes 31.

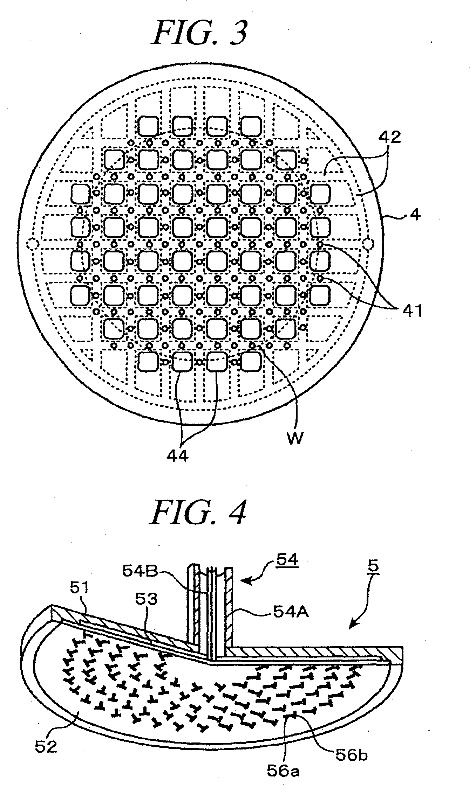

Further, provided between the mounting table 21 and the first gas supply unit 3 in the processing chamber 20 is a second gas supply unit 4 having, e.g., a plane shape of a substantially circle for dividing them, for example. The second gas supply unit 4 is made of a conductor such as an aluminum alloy containing magnesium (Mg) or aluminum-containing stainless steel and a plurality of second gas supply holes 41 is formed in a surface thereof facing the mounting table 21. Formed within the gas supply unit 4 is a grid-patterned gas flow path 42 communicated with an end of the gas supply hole 41 as illustrated in Fig. 3, for example, and the gas flow path 42 is connected with an end of a second gas supply channel 43. Further, the second gas supply unit 4 is provided with a plurality of openings 44 which pass through the second gas supply unit 4. The plasma or a source gas in the plasma passes through the openings 44 toward the space below the gas supply unit 4 and the openings are formed between the gas flow paths 42 adjacent to each other, for example.

The second gas supply unit 4 is connected with a gas supply source 45 for supplying a 2-butyne gas serving as a source gas and a gas supply source 35 for supplying a Si₂H₆ gas serving as a source gas via the second gas supply channel 43. These 2-butyne gas and Si₂H₆ (disilane) gas flow through the gas flow path 42 in sequence via the second gas supply channel 43 and are uniformly supplied into the space below the second gas supply unit 4 via the gas supply holes 41. Reference numerals V1 to V4 in the drawing denote a valve, and reference numerals MFC1 to MFC3 denote flow rate control units for respectively controlling a supply of the Ar gas, the 2-butyne gas, the Si₂H₆ gas supplied into the processing chamber 20.

Installed at a top portion of the first gas supply unit 3 is a cover plate 23 made of a dielectric material such as aluminum oxide via a sealing member (not illustrated) such as an O-ring, and installed at a top portion of the cover plate 23 is an antenna unit 5 in close contact with the cover plate 23. The antenna unit 5, as illustrated in Fig. 4, includes a flat antenna main body 51 with an open bottom surface having a circle plane shape and a circular plate-shaped planar antenna member (slot plate) 52 formed to close the opening of the bottom surface of the antenna main body 51 and having a plurality of slots therein. The antenna main body 51 and the planar antenna member 52 are made of a conductor and constitute a flat hollow circular waveguide. Further, a bottom surface of the planar antenna member 52 is connected with cover plate 23.

Further, a wavelength shortening plate 53 made of a low-loss dielectric material such as aluminum oxide or silicon nitride (Si₃N₄) is provided between the planar antenna member 52 and the antenna main body 51. The wavelength shortening plate 53 serves to shorten a wavelength of a microwave in order to shorten a wavelength in the circular waveguide. In this embodiment, a radial line slot antenna is made up of the antenna main body 51, the planar antenna member 52 and the wavelength shortening plate 53.

In this antenna unit 5, the planar antenna member 52 is mounted on the processing chamber 20 via a non-illustrated sealing member in such a manner that the planar antenna member 52 is in close contact with the cover plate 23. Further, the antenna unit 5 is connected with an external microwave generator 55 via a coaxial waveguide 54, so that a microwave having a frequency of, e.g., about 2.45 GHz or about 8.3 GHz is supplied thereto. Here, an external waveguide 54A of the coaxial waveguide 54 is connected to the antenna main body 51, and a central conductor 54B is connected to the planar antenna member 52 via an opening formed at the wavelength shortening plate 53.

The planar antenna member 52 is made up of a copper plate having a thickness of, e.g., about 1 mm and is provided with a plurality of slots 56 for generating, e.g., a circular polarized wave, as illustrated in Fig. 4. A plurality of pairs of the slots 56 arranged in a substantially T-shape with a slight gap therebetween is formed in, for example, a concentric-circle pattern or a spiral pattern along a circumferential direction. Since the slot 56a and the slot 56b are arranged substantially perpendicular to each other, the circular polarized wave including two perpendicular polarized wave components is radiated. At this time, the pairs of the slots 56a and 56b are arranged with a interval corresponding to a wavelength of the microwave compressed by the wavelength shortening plate 53, whereby the microwave is radiated from the planar antenna member 52 as a substantially plane wave. In the present invention, a plasma generator is made up of the microwave generator 55, the coaxial waveguide 54 and the antenna unit 5.

Furthermore, a bottom portion of the processing chamber 20 is connected with a gas exhaust pipe 24. The gas exhaust pipe 24 is connected with a vacuum pump 26 serving as a gas exhaust unit via a pressure control unit 25 constituting a pressure control means so as to evacuate the inside of the processing chamber 20 to a predetermined pressure.

Here, in the plasma film forming apparatus, a power supply to the microwave generator 55 or a high frequency power supply 22; an opening/closing of the valves V1 to V3 for supplying the plasma gas or the source gas; the flow rate control units MFC1 to MFC3; the pressure control unit 25, and so forth are controlled by a non-illustrated control unit on the basis of a program including steps for forming an amorphous carbon film containing Si in a predetermined condition. Moreover, the computer program including the steps for controlling the microwave generator 55 and the other respective units may be stored in a storage medium such as a flexible disk, a compact disk, a flash memory or an MO (Magneto-Optical disk), and then the respective units may be controlled to perform a process in a predetermined condition on the basis of the computer program.

Hereinafter, an example of a film forming method performed in the plasma film forming apparatus 2 will be explained. First of all, the silicon wafer W is loaded via a non-illustrated gate valve and mounted onto the mounting table 21. Formed on a surface of the wafer W is the n^{th} wiring circuit 1A as illustrated in Fig. 1(a), for example. Subsequently, the inside of the processing chamber 20 is evacuated to a predetermined pressure and a plasma gas, e.g., an Ar gas, to be excited by a microwave is supplied to the first gas supply unit 3 via the first gas supply channel 33 at a predetermined flow rate of, e.g., about 280 sccm. Meanwhile, a 2-butyne gas serving as a film forming gas is supplied to the second gas supply unit 4 serving as a source gas supply unit via the second gas supply channel 43 at a predetermined flow rate of, e.g., about 220 sccm and a Si₂H₆ gas serving as a film forming gas is also supplied thereto at a flow rate of, e.g., 4.5 sccm. Further, the inside of the processing chamber 20 is maintained at a processing pressure of, e.g., about 5.33 Pa (40 mTorr) and the surface of the mounting table 21 is set to have a temperature of, e.g., about 380°C.

Meanwhile, a high frequency wave (microwave) of 2.45 GHz, 3000 W is supplied from the microwave generator. The microwave propagates through the coaxial waveguide 54 in a TM mode, a TE mode or a TEM mode and reaches the planar antenna member 52 of the antenna unit 5, and the microwave radially propagates from the central portion of the planar antenna member 52 toward a circumference area thereof via the internal conductor 54B of the coaxial waveguide. Further, the microwave is radiated from the pairs of the slots 56a and 56b toward a processing space below the gas supply unit 3 via the cover plate 23 and the first gas supply unit 3.

Here, the cover plate 23 and the first gas supply unit 3 are made of a microwave transmissive material such as aluminum oxide to function as a microwave transmission window, so that a microwave penetrates them efficiently. At this time, since the pairs of the slits 56a and 56b are arranged as described above, the circular polarized wave is uniformly radiated throughout the plane surface of the planar antenna member 52 and thus an electric field density of the processing space thereunder becomes uniform. Further, uniform plasma having high density is excited by energy of the microwave throughout the large processing space. Moreover, the plasma is introduced into the processing space below the gas supply unit 4 through the openings 44 of the second gas supply unit 4 and activates the 2-butyne gas and the Si₂H₆ gas supplied from the gas supply unit 4 into this processing space, i.e., excites them into plasma, and then forms active species.

These active species are deposited on the wafer W, so that the amorphous carbon film 10 made up of a hydrogen atom, a carbon atom and a silicon atom is formed. Then, the wafer W on which the amorphous carbon film is formed is unloaded from the processing chamber 20 via the non-illustrated gate valve. Here, a series of operations of loading the wafer W into the processing chamber 20; performing the process under a preset condition; and then unloading it from the processing chamber 20 are carried out by controlling the respective units by the control unit or the program stored in the storage medium.

In the foregoing embodiment, the amorphous carbon film 10 made up mainly of carbon and hydrogen has a ratio of the hydrogen atom H to the carbon atom C in the film in the range of 0.8 < H/C < 1.2, more desirably, in the range from about 0.9 or more to about 1.1 or less. During film formation, the amorphous carbon film 10 containing an appropriate amount of the Si, e.g., Si atomic ratio of 10% or less in the film, more desirably, 5% or less has a slight increase in a dielectric constant to about 3.3 or less, but by adjusting processing conditions during film formation, it is possible to obtain a value of 3.0 or less. Here, as a conventional low-k barrier film, SiCN and SiCH made up mainly of silicon may be used. The SiCN film has a dielectric constant of about 5.0. Though it is possible to lower a dielectric constant of the SiCH film by making it porous, its barrier property becomes deteriorated due to a porous property. Therefore, the SiCH film actually serving as the barrier film has a dielectric constant of about 3.5 or more. As stated in the following embodiment, since the amorphous carbon film 10 of the present invention is formed with a high elastic modulus, film peeling is suppressed even if a stress is applied thereon. Furthermore, by addition of the Si, thermal contraction of the amorphous carbon film 10 is suppressed. By an annealing process in the process of manufacturing the semiconductor device, the film peeling is suppressed since a thermal contraction rate is low and a reduction of a film thickness is suppressed. As a result, it is possible to make use of advantageous properties of the amorphous carbon film 10 such as a low dielectric constant and a barrier property against a metal, e.g., Cu.

However, there is a high possibility that a CF film can be used as an interlayer insulating film since a dielectric constant thereof can be 2.2 or less. The amorphous carbon film has a high adhesivity with the CF film, so that it is advantageous for implementing the semiconductor device using the CF film.

Furthermore, though it is desirable that the 2-butyne gas is used as a hydrocarbon gas having a multiple bond, it may be possible to use a 1-butyne gas for film formation. In addition, it may be possible to use, but not limited to such butyne gases, a hydrocarbon gas having a double bond such as a C₂H₄ (ethylene) gas or a hydrocarbon gas having a triple bond such as a C₂H₂ (acetylene) gas, a C₅H₁₀(1-pentyne, 2-pentyne) gas for film formation. Moreover, in case that the film formation is performed by using a gas having the triple bond such as the acetylene, the second gas supply channel 43 is further branched in the film forming apparatus 2 and the branched ends are respectively connected with a gas supply source storing a H₂ (hydrogen) gas therein and a gas supply source storing an acetylene gas therein. During film formation, the H₂ gas, the acetylene gas and the Si₂H₆ gas are supplied to the processing chamber 20.

Though the above-stated amorphous carbon film 10 contains an appropriate amount of the Si, the amorphous carbon film may further contain an appropriate amount of one sort or two sorts or more of elements such as B (boron), N (nitrogen), Li (lithium), W (tungsten), Ti (titanium), S (sulfur), aluminum (A1), or the like in addition to Si. In this case, it is advantageous in that its mechanical strength can be higher. The amorphous carbon film 10 functions as a barrier film which prevents a compositional element of the wiring metal 12 of the n^{th} arrangement circuit 1A from being diffused into the interlayer insulating film 14 of the (n+1)^{th} wiring circuit 1A.

In the foregoing embodiment, there has been explained an exemplary application, e.g., a manufacturing method, of the amorphous carbon film as the barrier film of the Cu wiring. In addition to this, in the following examples, there will be explained other application examples of the amorphous carbon film of the present invention.

### (Other application example 1)

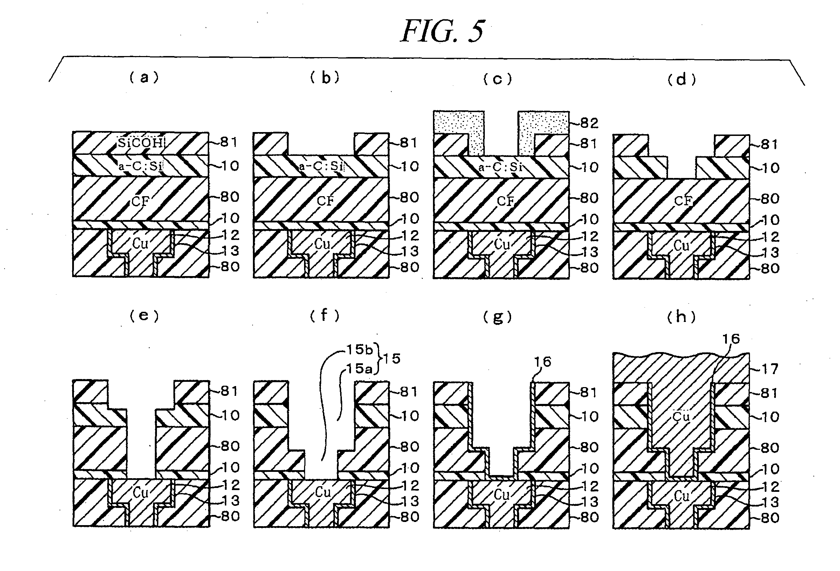

In this example, an amorphous carbon film of the present invention is used as a hard mask for forming a recess portion for burying a copper wiring 12 in an interlayer insulating film 80 made up of a CF film. The hard mask functions as a mask in an etching process and does not affect a property of a device even if it remains thereon. In this example, the hard mask is used for maintaining a function as a mask after a resist mask disappears in the etching process. As an example of this embodiment, a case where a (n+1)^{th} wiring circuit is formed on an n^{th} (n is integer of 1 or greater) wiring circuit will be explained with reference to Fig. 5. Furthermore, in Fig. 5, a film which is the same as the wiring circuit of Fig. 1 is assigned the same reference numeral, and the CF film 80, instead of the SiCOH films 11 and 14, is used for the purpose of a high-speed operation of the semiconductor device but a low dielectric constant film having an upper and lower two-layered structure may be a combination of the CF film and the SiCOH film. First of all, layered on the n^{th} wiring circuit is a lower amorphous carbon film 10 serving as the barrier film, an interlayer insulating film 80 made up of the CF film, an amorphous carbon film 10 of the present invention and a SiCOH film 81 in sequence (Fig. 5(a)). At this time, the SiCOH film 81 serves as the hard mask. Subsequently, formed on the SiCOH film 81 is a non-illustrated resist mask, and the SiCOH film 81 is etched by plasma containing, e.g., active species of a halide by using the resist mask to thereby obtain a predetermined pattern (Fig. 5(b)).

Thereafter, a resist film 82 is formed on a surface of the SiCOH film 81 and the amorphous carbon film 10, and a pattern having a narrower width than that of the predetermined pattern is formed (Fig. 5(c)). Then, after the amorphous carbon film 10 is etched by plasma of a CF-based gas by using the resist mask 82, the resist mask 82 is removed (Fig. 5(d)). Subsequently, the CF film 80 is etched by, e.g., oxygen plasma and the exposed lower amorphous carbon film 10 is etched by the plasma of the CF-based gas together with the upper amorphous carbon film 10 (Fig. 5(e)). Here, since the lower amorphous carbon film 10 serves as the barrier film, it has a thin thickness, and the upper amorphous carbon film 10 is slightly etched.

Then, the upper amorphous carbon film 10 is etched by using a mask made up of the SiCOH film 81 and the CF film 80 is further etched to the middle portion thereof, whereby formed is a recess portion having a wider width than that of the recess portion formed by the previous etching process (Fig. 5(f)). Here, a recess portion 15b having a narrower width corresponds to a via hole and a recess portion 15a having a wider width corresponds to a circuit wiring burying area (trench) of the wiring circuit. Thereafter, a conductive barrier metal 16 which is a Ta/Ti layered film, for example, is formed on a surface of the recess portion 15 (Fig. 5(g)); after a Cu metal 17 is buried in the recess portion 15 (Fig. 5(h)), the redundant Cu metal 17, the SiCOH film 81 and part or all of the amorphous carbon film 10 are removed by CMP; and a wiring 18 electrically connected with a wiring 12 is formed, whereby a (n+1)^{th} wiring circuit is formed.

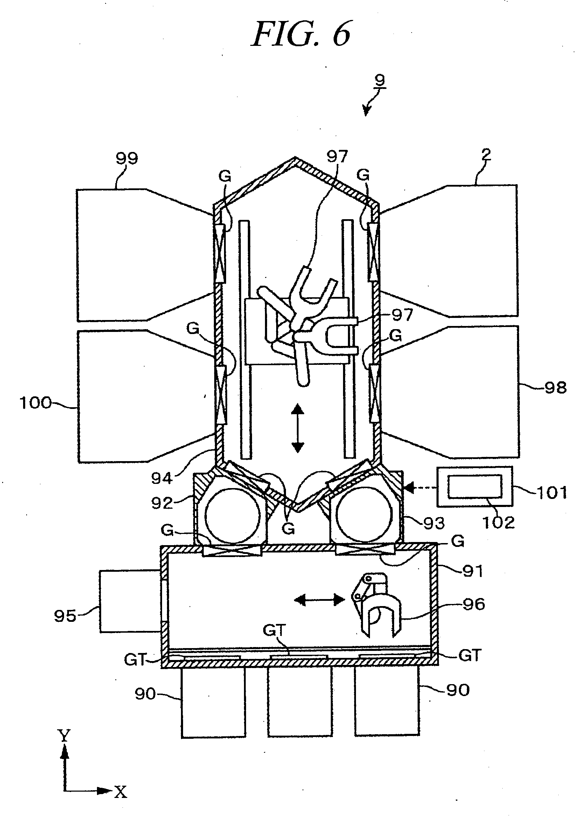

Hereinafter, an example of a semiconductor manufacturing apparatus for performing a manufacturing method of a layered structure illustrated in Fig. 5(a) will be explained with reference to Fig. 6. In Fig. 6, a reference numeral 90 denotes a carrier; a reference numeral 91 is a first transfer chamber; reference numerals 92 and 93 denote load lock chambers for controlling an atmosphere during wafer transfer; a reference numeral 94 denotes a second transfer chamber; and a reference numeral 95 denotes an alignment chamber. The inside of first transfer chamber 91 is in an atmospheric atmosphere and the second transfer chamber 94 is in a vacuum atmosphere. A reference numeral 96 denotes a first transfer mechanism and a reference numeral 97 is a second transfer mechanism. Furthermore, the second transfer chamber 94 is airtightly connected to the plasma film forming apparatus 2 for forming the amorphous carbon film 10 as illustrated in Figs. 2 to 4; a film forming apparatus 98 for forming the interlayer insulating film 80 made up of the CF film; a film forming apparatus 99 for forming the SiCOH film 81; and an annealing apparatus 100 for performing an annealing process on a wafer in a N₂ gas atmosphere at a temperature of, e.g., about 400°C. Further, in Fig. 6, a reference numeral G denotes a gate valve (division valve) for dividing the load lock chambers 92 and 93 from the first transfer chamber 91 or the second transfer chamber 94, or for dividing the second transfer chamber 94 from the film forming apparatuses 2, 98 and 99 or the annealing apparatus 100. Moreover, a reference numeral GT in Fig. 6 denotes a door.

Furthermore, the semiconductor manufacturing apparatus 9 includes, as illustrated in Fig. 6, a control unit 101 implemented by, e.g., a computer, which includes a data processing unit composed of a program, a memory and a CPU. The program includes commands (steps) for transmitting a control signal from the control unit 101 to the respective units of the semiconductor manufacturing apparatus 9 so as to proceed with the following transfer process in sequence. Further, for example, the memory stores processing parameters such as a processing pressure, a processing temperature, a processing time, a gas flow rate, a power value in the respective apparatuses 2, 98, 99 and 100 and when the CPU executes a command from the program, these processing parameters are read out and a control signal in response to the read parameters is transmitted to each part of the semiconductor manufacturing apparatus 9. The program (including a program for input operation or display of processing parameters) is stored in a storage unit 102 such as a computer storage medium, e.g., a flexible disk, a compact disk, a hard disk, an MO (Magneto-Optical disk) and then installed in the control unit 101.

Hereinafter, there will be explained a transfer path in the semiconductor manufacturing apparatus 9 configured as stated above. First of all, a wafer is transferred from the carrier 90 to the first transfer mechanism 96, the load lock chamber 92 (or 93), the second transfer mechanism 97 and to the film forming apparatus 2 (96 〉̶ 92 (93) 〉̶ 97 〉̶ 2), in which film formation of the amorphous carbon film 10 serving as the barrier film in the present invention is performed. Then, the wafer is transferred to the annealing apparatus 100 via the second transfer mechanism 97 and an annealing process is performed on the wafer in the annealing apparatus 100 at a temperature of, about 300°C. By the annealing process, dangling bonds arising in the film formation of the amorphous carbon film 10 are removed. Thereafter, the wafer is transferred to the film forming apparatus 98 via the second transfer mechanism 97 and film formation of the interlayer insulating film 80 made up of the CF film is performed in the film forming apparatus 98. Subsequently, the wafer is transferred, via the second transfer mechanism 97, to the film forming apparatus 2 in which film formation of the amorphous carbon film 10 serving as the hard mask on the CF film 80 in the present invention is performed. Then, the wafer is transferred to the annealing apparatus 100 via the second transfer mechanism 97 and the same annealing process as stated above is performed in the annealing apparatus 100. Thereafter, the wafer is transferred, via the second transfer mechanism 97, to the film forming apparatus 99 in which film formation of the SiCOH film 81 serving as the hard mask on the amorphous carbon film 10 is performed. Subsequently, the wafer is returned to the second transfer mechanism 97, the load lock chamber 92 (or 93), the first transfer mechanism 96 and to the inside of the carrier 90 (97 〉̶ 92(93) 〉̶ 96 〉̶ 90) along the transfer path.

Here, the CVD apparatus as illustrated in Figs. 2 to 4 can be used as the film forming apparatus 98 for forming the CF film 80 and the film forming apparatus 99 for forming the SiCOH film 81. That is, for the film forming apparatus 98, the first gas supply channel 33 is connected with a plasma gas, e.g., an Ar gas, supply source and the second gas supply channel 43 is connected with a C₅F₈ gas supply source in the CVD apparatus as illustrated in Figs. 2 to 4. Further, for the film forming apparatus 99, the first gas supply channel 33 is connected with a plasma gas, e.g., an Ar gas, supply source and oxygen gas supply source, and the second gas supply channel 43 is connected with a trimethylsilane gas supply source in the CVD apparatus as illustrated in Figs. 2 to 4. Furthermore, in the annealing apparatus 100, a processing chamber may include a mounting table, a heater for heating a wafer and a N₂ gas supply unit, and an annealing process is performed on the amorphous carbon film 10 of the present invention by, for example, heating the wafer at a temperature in the range from about 200°C to about 400°C.

### (Other application example 2)

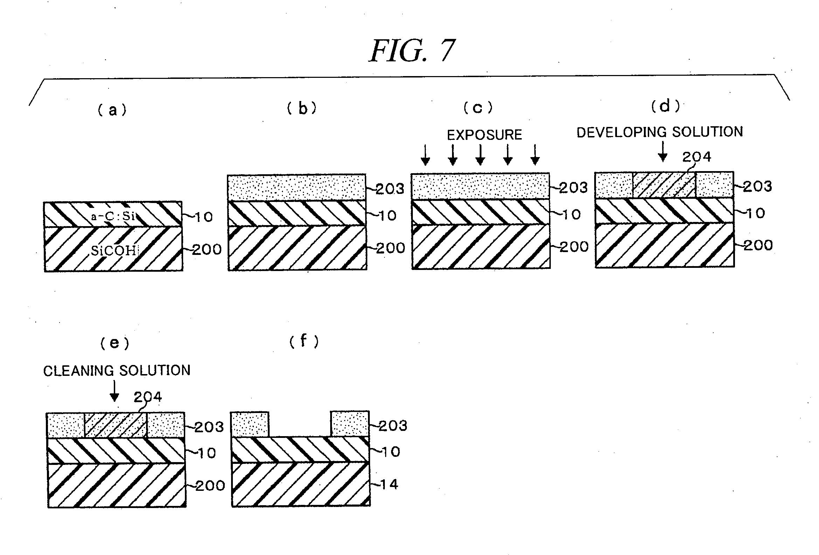

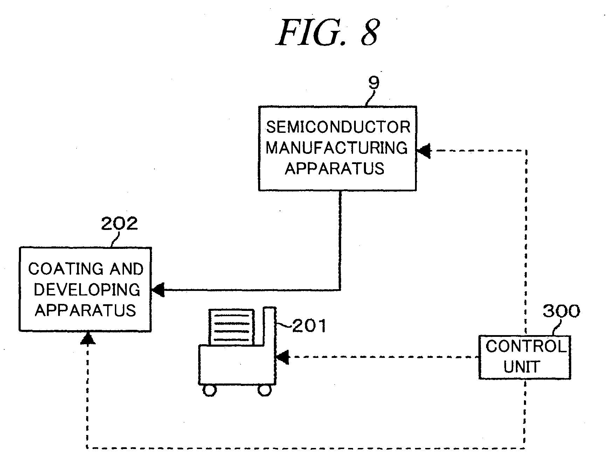

In addition, the amorphous carbon film of the present invention can be used as an anti-reflection film for preventing a light irradiated on a substrate surface from scattering during exposure process. In this regard, there will be an explanation with reference to Figs. 7 and 8. First of all, in the present example, as illustrated in Fig. 7, a SiOCH film 200 having a low dielectric constant and the amorphous carbon film 10 of the present invention are formed on the substrate surface in sequence (Fig. 7(a)), and the process-completed wafer is accommodated in the carrier 90. Then, the carrier 90 is transferred to a coating and developing apparatus 202 by a transfer robot 201. In the coating and developing apparatus 202, formed on the amorphous carbon film 10 is a chemically amplified resist film 203, for example (Fig. 7(b)). Subsequently, an exposure process is performed on the resist film 203 (Fig. 7(c)). At this time, if the resist film 203 is a negative type, for example, a light-exposed portion is insoluble, and if it is a positive type, the light-exposed portion is soluble. In this example, the negative type resist film 203 is used. Subsequently, a developing solution is coated onto the negative type resist film 203. After coating with the developing solution, by maintaining such a state for a predetermined time period, a soluble portion 204 with respect to the developing solution is dissolved (Fig. 7(d)). Then, by washing away the developing solution on the amorphous carbon film 10 by a cleaning solution (Fig. 7(e)) and drying the washed portion, a predetermined resist pattern 205 is obtained (Fig. 7(f)). Further, as illustrated in Fig. 8, in this example, the semiconductor manufacturing apparatus 9, the coating and developing apparatus 202 and the transfer robot 201 are controlled by the control unit 300. After the wafer on which the film formation process is performed in the semiconductor manufacturing apparatus 9 is returned to the inside of the carrier 90 the carrier 90 mounted in the semiconductor manufacturing apparatus 9 is transferred to the coating and developing apparatus 202 by the transfer robot 201 in response to the control signal transmitted from the control unit 300 to the transfer robot 201.

Hereinafter, a measurement result of reflectivity of the amorphous carbon film 10 of the present invention will be described. The measurement result is obtained by irradiating an ArF laser beam having a wavelength of 193 nm and a KrF laser beam having a wavelength of 248 nm on each surface of an experimental sample 1, which is an amorphous carbon film 10 having a thickness of 30 nm formed on a silicon wafer surface, and an experimental sample 2, which is an amorphous carbon film 10 having a thickness of 100 nm formed on a silicon wafer surface, and measuring reflectivity of the experimental samples 1 and 2 against each laser beam. The measurement result is exhibited in [Table 1].

**[Table 1]**

| | Experimental Sample 1 | Experimental Sample 2 |
|---|---|---|
| Amorphous carbon film | 30 nm | 100 nm |
| KrF laser beam | 5.7% | 3.5% |
| ArF laser beam | 6.5% | 12.1% |

As exhibited in [Table 1], in case that the amorphous carbon film 10 has a thick thickness, its reflectivity against the KrF laser beam is low, whereas its reflectivity against the ArF laser beam is high. Accordingly, in order to obtain a low reflectivity, it is needed to control the film thickness of the amorphous carbon film 10 depending on an exposure light source irradiated onto the amorphous carbon film 10 instead of making the film thickness of the amorphous carbon film 10 thick. Furthermore, as long as a film has reflectivity of about 10% or less, it can fully function as the anti-reflection film. Therefore, the amorphous carbon film of the present invention can be used as the anti-reflection film. Furthermore, since the amorphous carbon film 10 of the present invention functions as the hard mask as well as the anti-reflection film under the resist film 203, it is not necessary to deposit thin films each having such a function as in the past and thus a single sheet of the amorphous carbon film is sufficient. For this reason, it is possible to simplify a manufacturing process of a semiconductor device and improve a throughput.

### (Other application example 3)

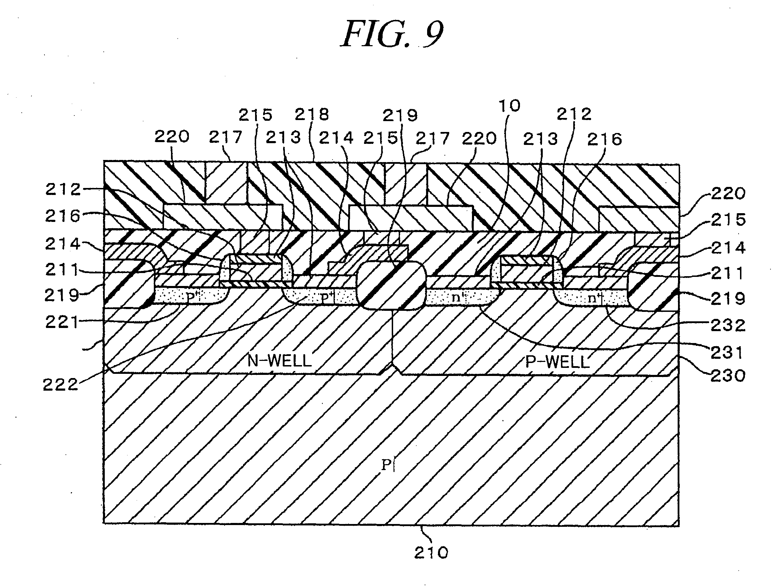

Besides, the amorphous carbon film of the present invention can be used as an insulating layer embedding a transistor therein instead of a BPSG (Boron Phosphorous Silicate Glass) film. In this manner, by using the amorphous carbon film as the insulating layer embedding the transistor, it is possible to reduce a parasitic capacitance incurred between a wiring and a gate electrode in the transistor. Fig. 9 illustrates a CMOS transistor employing the amorphous carbon of the present invention as the insulating layer. In Fig. 9, a reference numeral 210 denotes a p-type silicon layer, a reference numeral 220 denotes a n-well layer, a reference numeral 230 denotes a p-well layer, reference numerals 221 and 222 denote p⁺-type portions serving as a source and a drain respectively, reference numerals 231 and 232 denote n⁺-type portions serving as a source and a drain respectively, a reference numeral 211 denotes a gate oxide film, a reference numeral 212 denotes a gate electrode, a reference numeral 213 denotes a polysilicon film, a reference numeral 214 denotes an extraction electrode, a reference numeral 219 denotes a device isolation film, and a reference numeral 10 denotes the amorphous carbon film of the present invention. Furthermore, a reference numeral 215 denotes a wiring made of, e.g., tungsten (W) and a reference numeral 216 denotes a sidewall. Moreover, an interlayer insulating film 218 in which a wiring layer 217 made of, e.g., copper and an electrode 220 are embedded is further layered on the amorphous carbon film 10.

### (Other application example 4)

Furthermore, the amorphous carbon film of the present invention can be used as an adhesive film (protective film) having a thin thickness of, e.g., about 10 nm or less for improving adhesivity between the CF film serving as the interlayer insulating film and the SiCOH film serving as the hard mask. That is, when the SiCOH film is formed on the CF film, an organic source vapor (gas) such as trimethylsilane and an oxygen gas are excited into plasma, so that oxygen active species react with carbon contained in the CF film to form and release carbon dioxide (CO₂). For this reason, a densification in a surface portion of the CF film is decreased and thus the adhesivity between the CF film and the SiCOH film is deteriorated. Therefore, by forming the amorphous carbon film prior to the SiCOH film formation on the CF film, the amorphous carbon film prevents the oxygen active species used for the SiCOH film formation from being introduced into the SiCOH film and as a result, the adhesivity between the CF film and the SiCOH film is improved. In this manner, by interleaving the amorphous carbon film between the CF film and a film formed by oxygen-containing plasma, adhesivity between the film and the CF film can be obtained.

### (Experimental example 1-1)

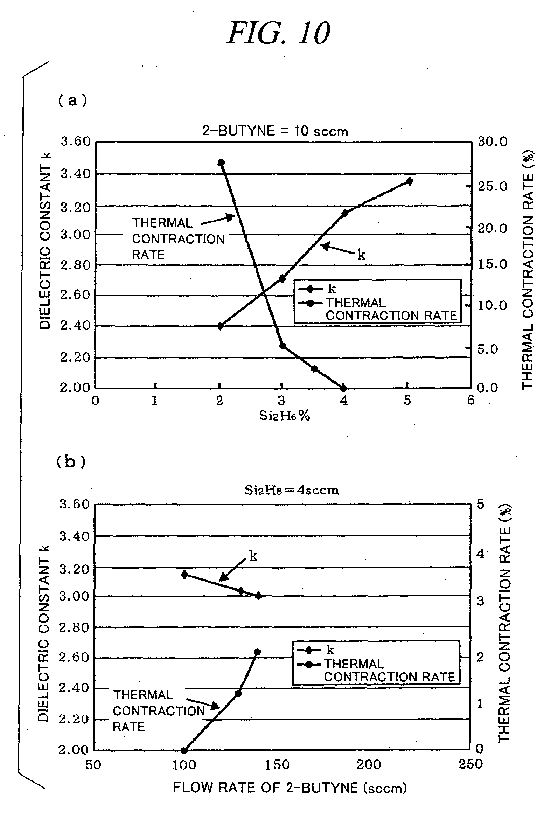

As experimental example 1-1, in accordance with a film forming method describe in the above examples, an amorphous carbon film is formed on a wafer by setting a flow rate of 2-butyne to be about 100 sccm and setting a flow rate of Si₂H₆ gas to be various values. After exposing this amorphous carbon film to the air and measuring its dielectric constant (k) and film thickness, an annealing process was performed under an atmospheric pressure in a N₂ (nitrogen) gas atmosphere at a temperature of, e.g., about 400°C. After the annealing process, the film thickness was measured again and a thermal contraction rate (thickness contraction rate of the annealed film with respect to the before-annealed film) was calculated. Fig. 10(a) is a graph showing a result thereof. The vertical axis represents a dielectric constant and a thermal contraction rate, and the horizontal axis represents a ratio of the flow rate of Si₂H₆ gas to the flow rate of the 2-butyne.

### (Experimental example 1-2)

In the same manner as experimental example 1-1, an annealing process was performed after forming amorphous carbon film, and then a dielectric constant and a thermal contraction rate was measured. However, unlike experimental example 1-1, a flow rate of a Si₂H₆ gas is set to be about 4 sccm and a flow rate of a 2-butyne gas is changed for each process. Fig. 10(b) is a graph showing such a result.

As can be seen from Figs. 10(a) and 10(b), as the flow rate of the Si₂H₆ gas with respect to the flow rate of the 2-butyne gas increases, the thermal contraction rate decreases but the dielectric constant increases. Therefore, there is a trade-off relationship between the thermal contraction rate and the dielectric constant. It can be seen that it is possible to control the dielectric constant and the thermal contraction rate of the amorphous carbon film by respectively controlling the flow rate of the 2-butyne gas and the flow rate of the Si₂H₆ gas. In order to make use of advantages of the amorphous carbon film having a low dielectric constant, it is desirable to set the dielectric constant to be about 3.3 or less, more desirably, 3.0 or less. In this case, it is possible to obtain a very low thermal contraction rate of about 3.0%.

### (Experimental example 1-3)

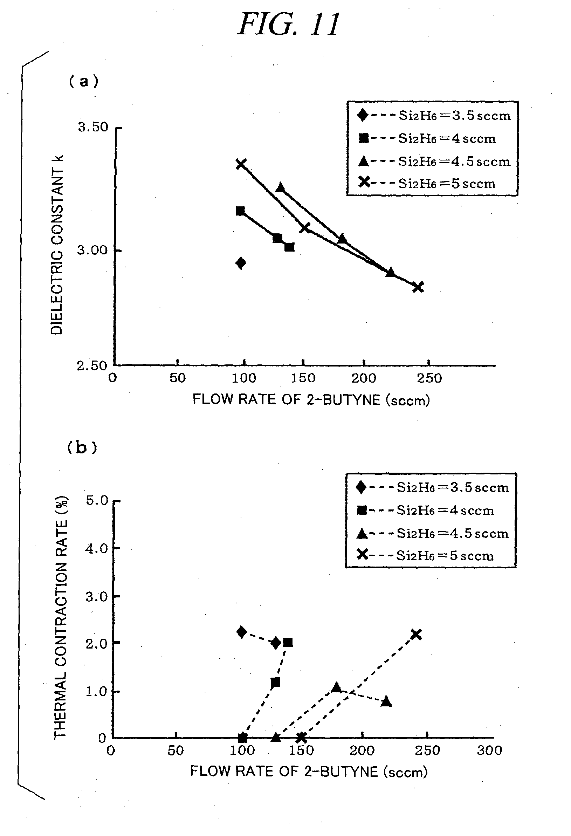

In the same manner as experimental example 1-1 and experimental example 1-2, an amorphous carbon film is formed on a wafer. At this time, by varying each of a flow rate of a 2-butyne gas and a flow rate of a Si₂H₆ gas, the gas flow rates each corresponding to a desirable dielectric constant (k) and a desirable thermal contraction rate was measured. Fig. 11 (a) is a graph showing a dielectric constant of each film obtained from the measurement and a flow rate of each gas. Fig. 11(b) is a graph showing a thermal contraction rate of each film and a flow rate of each gas. As a result of evaluation, in case that the flow rate of a 2-butyne gas and a Si₂H₆ gas are about 220 sccm and about 4.5 sccm respectively, it is possible to obtain the dielectric constant (k) of about 2.88 and the thermal contraction rate of about 0.7% as the most desirable values.

### (Experimental example 2)

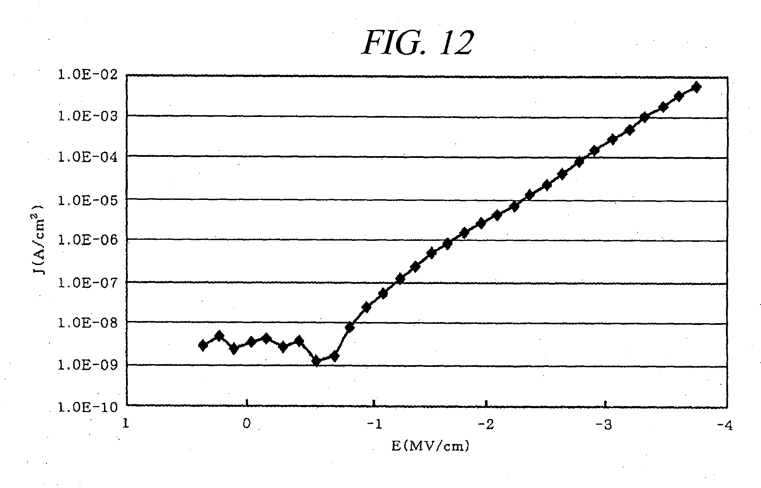

With respective to the wafer, obtained from experimental example 1-3, having thereon the amorphous carbon film having the dielectric constant (k) of about 2.88 and the thermal contraction rate of about 0.7%, a leakage current characteristic of the amorphous carbon film was examined by applying a voltage from the wafer. Fig. 12 is a graph showing a result thereof, and a horizontal axis represents strength of an electric field and a vertical axis represents a leakage current density. It is found that even if the strength of the electric field is increased, the leakage current density is low, so that the obtained amorphous carbon film has a sufficient insulation property. Therefore, it can be used as an insulating film in a semiconductor device.

### (Experimental example 3)

By using the film forming apparatus 2 in the above-described embodiment, four kinds of amorphous carbon film samples, which are indicated in [Table 2], are formed on a wafer. In the table, a Si addition rate is a ratio of a flow rate of a Si₂H₆ gas to a flow rate of a 2-butyne gas supplied to a processing chamber 20 during film formation. An experimental sample 1 is an amorphous carbon film having the most desirable properties among films used in experimental examples 1-3. An experimental sample 2 is an amorphous carbon film among films used in experimental example 1-1. Comparative samples 1 and 2 are amorphous carbon films formed by only a 2-butyne gas without supplying a Si₂H₆ gas during film formation process. Further, film formation is performed in the comparative samples 1 and 2 with differently set parameters such as an internal pressure of the processing chamber 20, and as indicted in [Table 2], they have different dielectric constants and thermal contraction rates. The comparative sample 2 is formed, under a condition that Si is not contained, by controlling the respective parameters such that it has desirable dielectric constant and thermal contraction rate.

**[Table 2]**

| | Dielectric constant(k) | Thermal contraction rate | Si addition rate |
|---|---|---|---|
| Experimental Sample 1 | 2.88 | 0.7% | 2% |
| Experimental Sample 2 | 3.35 | 0% | 5% |
| Comparative Sample 1 | 2.71 | 16% | 0% |
| Comparative Sample 2 | 3 | 6% | 0% |

### (Speculation)

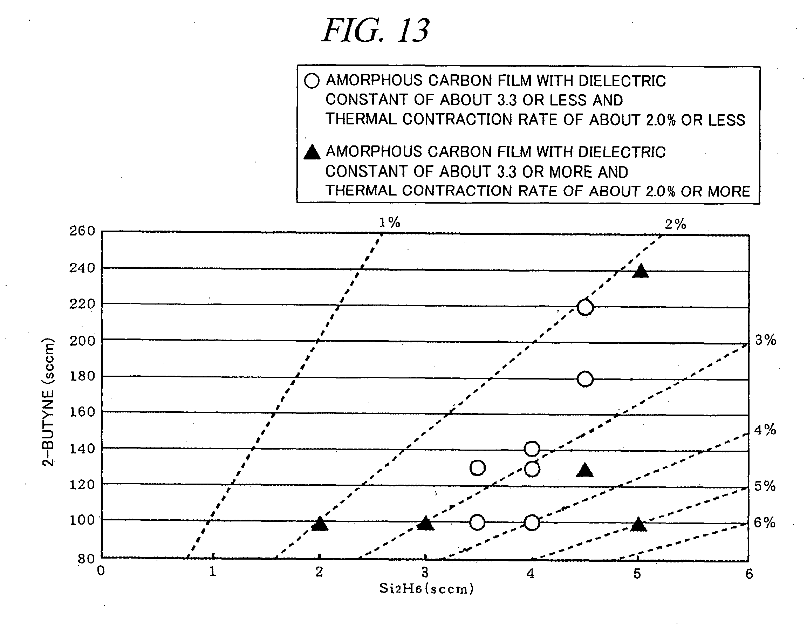

Data obtained from experimental example 1 to experimental example 3 is indicated as a graph as illustrated in Fig. 13. Herein, it has been sought to find processing conditions of the amorphous carbon film having practically advantageous properties of a dielectric constant of about 3.3 or less and a thermal contraction rate of about 2.0% or less. As can be seen from Fig. 13, the film having such properties has a ratio of a flow rate of a Si₂H₆ gas to a flow rate of a 2-butyne gas in the range from about 2% or more to about 4% or less. More desirably, the flow rate of the Si₂H₆ gas is in the range from about 3 sccm or more to about 5 sccm or less. Further, a dashed straight line in Fig. 13 shows the ratio (%) of the flow rate of the Si₂H₆ gas to the flow rate of the 2-butyne gas.

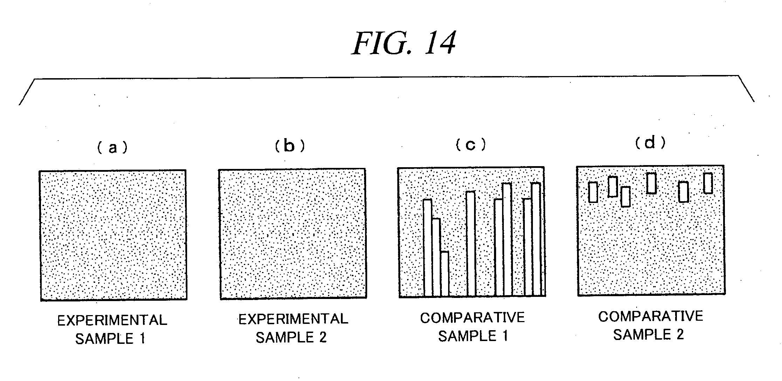

The longitudinal cross sections of the obtained experimental samples and comparative samples are photographed by a SEM. Figs. 14(a) to 14(d) schematically illustrate the photographs thereof. As for the experimental samples 1 and 2 which contain Si, non-crystals are isotropically grown and fine grain boundaries are distributed in a uniform manner. Contrary to this, as for the comparative sample 1 which does not contain Si, non-crystals are anisotropically grown in a column shape in a longitudinal direction, and as for the comparative sample 2, anisotropic growth of crystals is observed in the vicinity of a surface in a cross section thereof. In case that the crystals are anisotropically grown, a gas or a current can be easily flown through a gap between the crystals, but in case that the crystals are isotropically grown, a gas or a current can not be easily flown through a gap between the crystals, so that a current leakage is suppressed and film strength becomes increased. Accordingly, it is deemed that the respective experimental samples are superior in a performance for suppressing a current leakage and film strength to the respective comparative samples. Furthermore, according to an evaluation on each sample with an XRD (X-Ray Diffractometer), it has been found that the films of the samples become amorphous.

### (Experimental example 4-1)

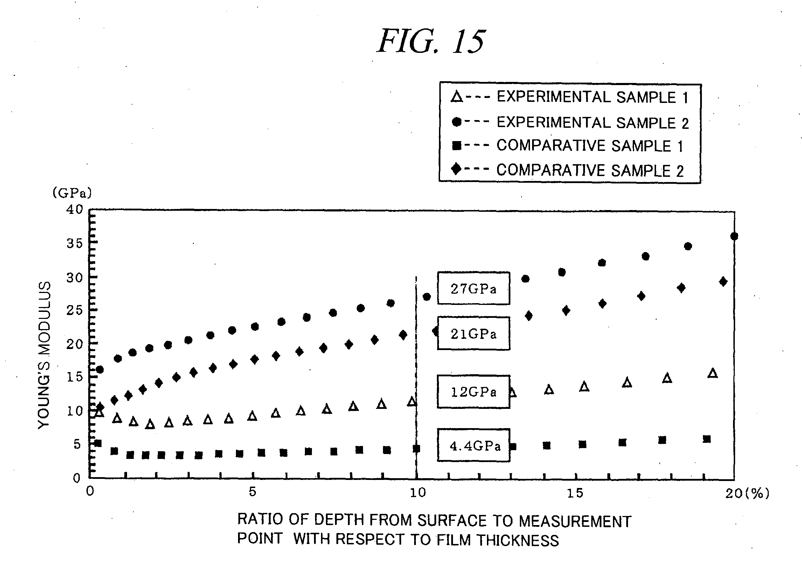

Subsequently, with respect to the respective samples used in experimental example 3, there has been measured film strength and a Young's modulus as an index of elastic modulus. In experimental example 4-1, the measurement was taken by forming the respective samples on a silicon substrate, and in order to reduce effects of the silicon substrate, the respective samples are formed to have a film thickness of about 1000 nm. Fig. 15 is a graph showing a result of the measurement and its vertical axis represents the Young's modulus. The horizontal axis of the graph represents a ratio of a depth from a surface to a measurement point with respect to a film thickness. In the graph, values described in square frames are Young's modulus of each sample which is required from the graph when the ratio of the depth of the measurement point with respect to the film thickness is 10%. The experimental sample 1 containing Si has a desirable Young's modulus as 12 GPa which is higher than that of the comparative sample 1. Further, the experimental sample 2 has the highest Young's modulus as 27GPa among the samples.

### (Experimental example 4-2)

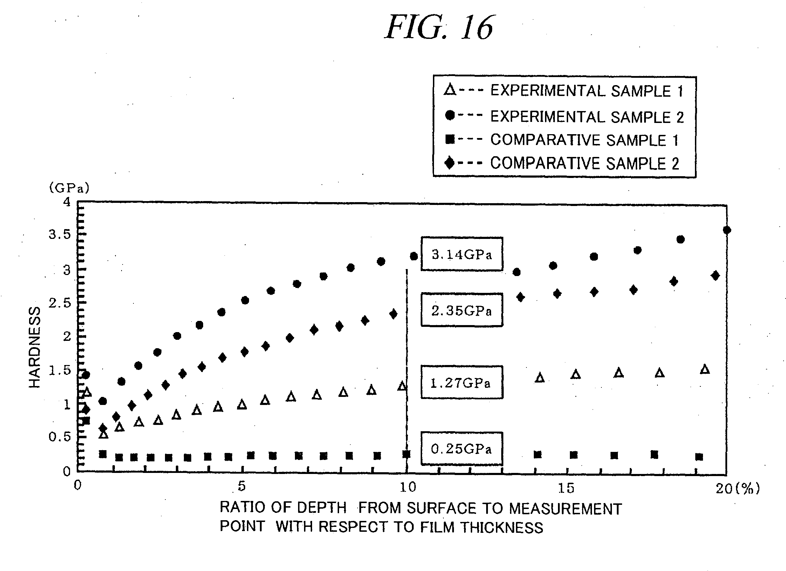

Thereafter, in the same manner as experimental example 4-1, with respect to the amorphous carbon films of the respective samples, there has been measured hardness as an index of film strength. In the same manner as experimental example 4-1, in order to reduce effects of a silicon substrate, the respective samples are formed to have a film thickness of about 1000 nm on the silicon substrate. Fig. 16 is a graph showing a result of the measurement and its vertical axis represents the hardness and its horizontal axis represents a ratio of a depth of a measurement point to a film thickness as indicated in a graph of Fig. 15. In the graph, values described in square frames represent hardness of each sample which is required from the graph when the ratio of the depth of the measurement point to the film thickness is 10%. The hardness becomes higher according to highness of the Young's modulus.

In accordance with experimental examples 4-1 and 4-2, the amorphous carbon films of the experimental samples 1 and 2 containing Si have a high Young's modulus and a high hardness than those of the comparative sample 1. Therefore, it can be seen that it is possible to improve an elastic modulus and film strength by addition of the Si. Further, the experimental sample 2 containing a large volume of Si has the highest Young's modulus and the highest hardness among the samples. Accordingly, it can be seen that if the amount of Si increases, such values can be increased.

### (Experimental example 5)

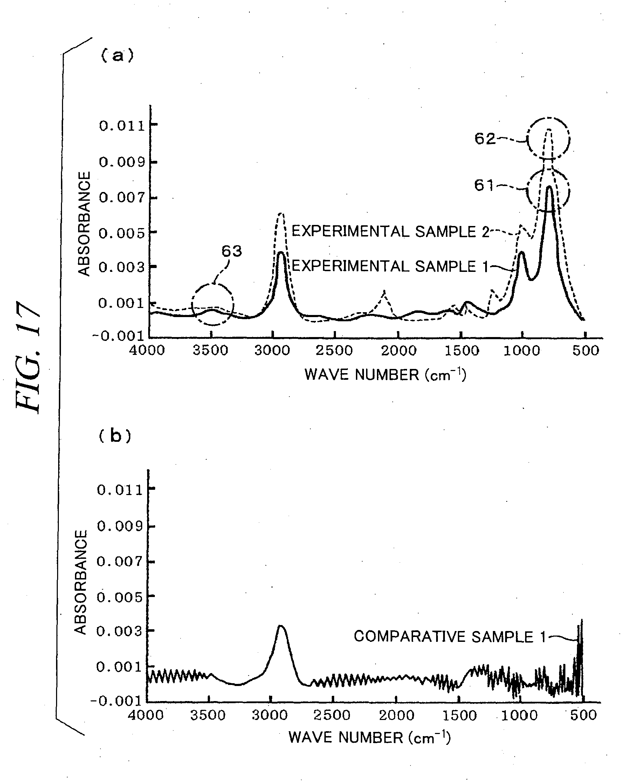

In experimental example 5, with respect to the films of the experimental samples 1 and 2 and the comparative sample 1, there has been measured an infrared spectrum by using a FT-IR (fourier transform-infrared ray spectroscopy) apparatus. Fig. 17(a) shows spectrums of the experimental samples 1 and 2, and Fig. 17 (b) shows a spectrum of the comparative sample 1. In the experimental samples 1 and 2, a peak showing a combination of Si and a methyl group appears in the range of a wave number from about 500 cm⁻¹ to about 1000 cm⁻¹ as illustrated in areas surrounded by dashed lines 61 and 62. Meanwhile, there is no peak in the spectrum of the comparative sample 1. Accordingly, there is likelihood that a C(carbon)-Si-C bond is formed in the films of the experimental samples 1 and 2, so that it is deemed that film strength is increased and a thermal contraction rate is improved by such a bond. Furthermore, in Figs. 17 (a) and 17 (b) , a peak appearing in the vicinity of a wave number of about 3000 cm⁻¹ shows a C-H bond.

However, if Si contained in the film reacts with a hydroxyl group to form a Si-OH bond is formed, a peak appears in the area 63 surrounded by a dotted line in the vicinity of 3500 cm⁻¹, but as illustrated in Fig. 17a, such a peak is not observed in the experimental samples 1 and 2. Therefore, even if the film contains the Si, there is no likelihood that the Si-OH bond is formed and thus the film absorbs moisture. It can be deemed that there is no possibility that film strength becomes deteriorated by such moisture absorption, or a current leakage occurs easily.

### (Experimental example 6)

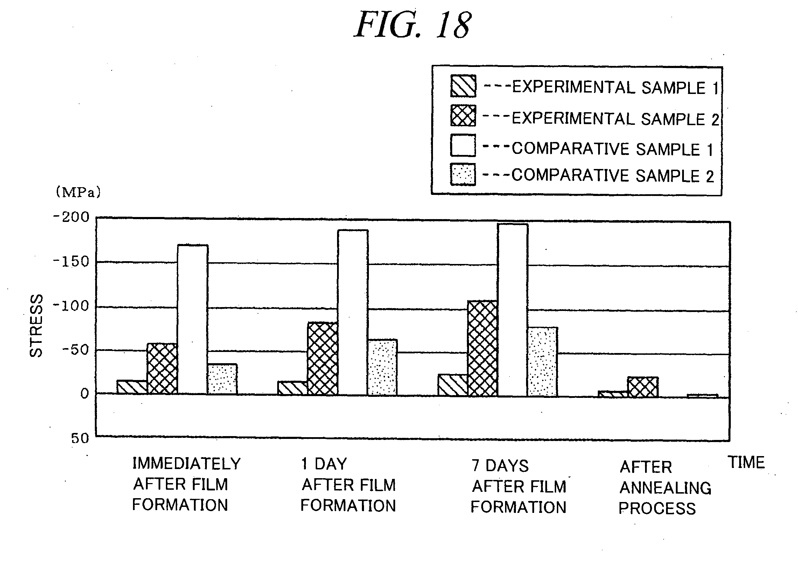

In experimental example 6, curvature of a plurality of wafers was measured in advance and then films of the experimental samples and the comparative samples are formed on the respective wafers. After a completion of these film formations, the curvature measurement was taken to the respective wafers at immediately after, 1 day after, and 7 days after the film formation, and with these measurement values and the measurement value obtained before film formation, a stress of each sample was calculated. The wafer after 7 days of the film formation is annealed in a N₂ atmosphere at a temperature of 400°C and a curvature measurement is taken to the annealed wafer and then a stress of each sample was calculated. Fig. 18 is a graph showing a stress of each sample whenever the measurements are made. The vertical axis of the graph represents a stress value of each sample, and as a change in the wafer curvature between before and after film formation is small, the stress value thereof becomes small.

As can be seen from the graph of Fig. 18, before the annealing process, it is found that the stress value is increased as time goes, and it can be seen that the experimental sample 1 has the smallest stress value among the samples and the smallest change as time goes. The experimental sample 2 also show a small change as time goes. Further, after the annealing process performed on each sample, the stress applied onto each wafer decrease. However, it is found that there is a big change in the stress in the comparative samples 1 and 2. On the contrary, a change in the stress in the experimental samples 1 and 2 is suppressed as compared to the comparative samples. When the stress applied onto the film and the change therein is small, the film is stable and has a little effect on other films in contact therewith. Accordingly, the amorphous carbon film with an additive silicon becomes stable, and even after the annealing process, a film peeling from the other film in contact does not easily occur, so that the effect of the present invention can be seen therefrom.

### (Experimental example 7)

Subsequently, with respect to the experimental sample 1 and the comparative sample 1, a composition of film was examined and exhibited in [Table 3] as below. Through this examination, it is found that the experimental sample 1 contains Si element but the comparative sample 1 does not contain Si element. Further, though O element is found in the experimental sample 1, a Si-OH bond is not identified therein in experimental example 5, so that it is deemed that the other bonds existing in the film contain the O element.

**[Table 3]**

| % | Experimental Sample 1 | Comparative Sample 1 |
|---|---|---|
| C | 43.0 | 51.2 |
| Si | 7.0 | - |
| H | 46.9 | 47.0 |
| O | 2.9 | 1.8 |

### (Experimental example 8-1)

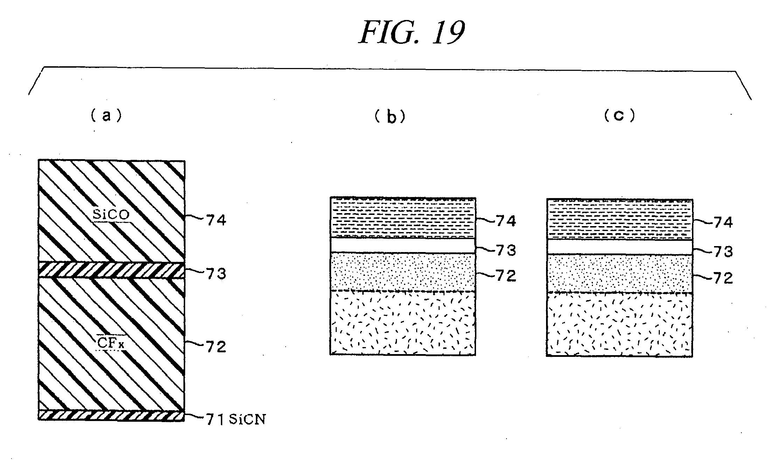

As illustrated in Fig. 19(a), a SiCN film 71, a CFx film 72, an amorphous carbon film 73 formed in the same manner as the above-described experimental sample 1, and a SiCO film 74 is layered on a wafer in sequence from the bottom. Further, the SiCN film 71, the CFx film 72, the amorphous carbon film 73 and the SiCO film 74 have the thicknesses of about 6 nm, about 150 nm, about 25 nm and about 100 nm respectively. After forming the layered film, a longitudinal cross section thereof is photographed by a SEM and then an annealing process is performed thereon in the same manner as experimental example 1-1. The annealing process was performed for an hour. After the annealing process, the longitudinal cross section of the layered film is photographed by the SEM again, and then there is made a comparison of the photographed images between before and after the annealing process.

Figs. 19(b) and 19(c) schematically show the SEM images before and after the annealing process respectively. In the SEM images, the thermal contraction (film thickness reduction) of the amorphous carbon film 73 is not observed, and after the annealing process, a void is not formed in the same film 73.

### (Experimental example 8-2)

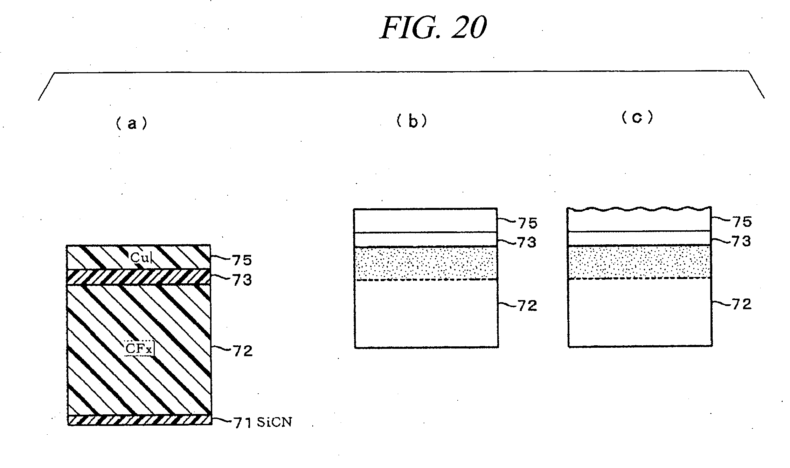

Then, as illustrated in Fig. 20(a), a layered film is formed on a wafer. The configuration of the layered film is the same as that of the layered film of experimental example 7-1 except that a Cu film 75 is formed instead of the SiCO film 74. The Cu film 75 has the film thickness of about 30 nm. There has been performed an annealing process on this layered film in the same manner as experimental example 8-1 and there is observed a change in SEM images of a longitudinal cross section of the layered film between before and after the annealing process.

Figs. 20(b) and 20(c) schematically show the SEM images before and after the annealing process respectively. In the SEM images, the thermal contraction (film thickness reduction) of the amorphous carbon film 73 is not observed, and after the annealing process, a void is not formed.

According to the results of experimental examples 8-1 and 8-2, it is found that the amorphous carbon film with an additive silicon is stable and thus a thermal contraction in the annealing process is suppressed. Therefore, the effect of the present invention can be seen therefrom.

### (Experimental example 9)

In experimental example 9, amorphous carbon films are formed on a plurality of wafers in a sequence of the film formation of the above-described embodiments. However, a flow rate of a 2-butyne gas and an internal pressure of the processing chamber 20 is set to be about 100 sccm and about 2.67 Pa (20 mTorr), respectively and then the film formation process is performed by varying a flow rate of a Si₂H₆ gas for each wafer). Subsequently, the film formation process is performed by varying a flow rate of a Si₂H₆ gas for each wafer under the same condition except that an internal pressure of the processing chamber 20 is set to be about 5.33 Pa (40 mTorr). With respect to the obtained film, a dielectric constant was measured and an annealing process was performed in the same manner as experimental example 1-1, and then a thermal contraction rate was measured.

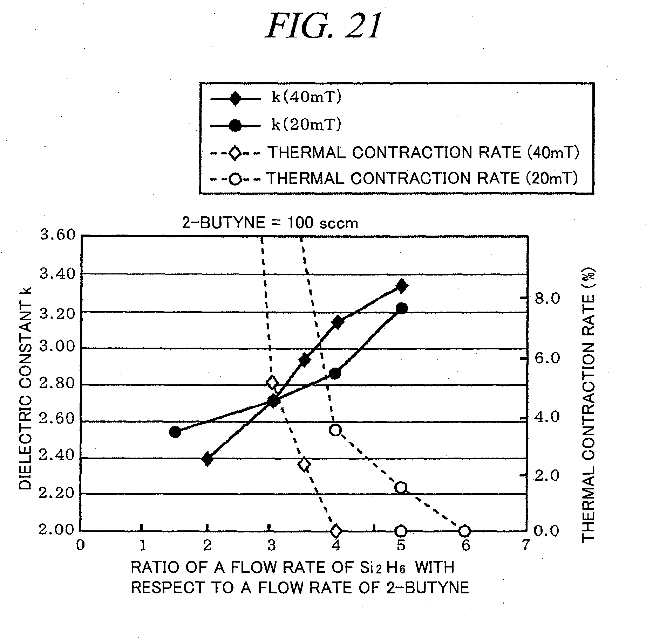

Fig. 21 is a graph showing a result of the measurement, and the vertical axis of the graph represents a dielectric constant and a thermal contraction rate and the horizontal axis thereof represents a ratio of a flow rate of a Si₂H₆ gas to a flow rate of a 2-butyne gas. It can be seen from the graph that if a Si₂H₆ gas supply is the same as a 2-butyne gas supply, it is possible to reduce the thermal contraction rate by increasing the pressure. Further, it can be seen that if the flow rate of the Si₂H₆ gas is equal to or less than 3%, it is possible to reduce the dielectric constant by increasing the pressure. However, if the internal pressure of the processing chamber 20 is high during film formation, a film formation rate D/R (deposition rate) becomes slow. For example, in case that the pressure is 13.3 Pa (100 mTorr), the D/R becomes 10 nm/min. Accordingly, it is desirable to control the internal pressure of the processing chamber 20 to be in the range from about 5.33 Pa (40 mTorr) to about 9.33 Pa (70 mTorr) during film formation.

## Claims

1. An amorphous carbon film, which contains hydrogen and carbon, is formed with an additive silicon and has a dielectric constant of about 3.3 or less.

2. The amorphous carbon film of claim 1, which is formed by exciting a hydrocarbon gas having a multiple bond and a silicon-containing gas into plasma.

3. A semiconductor device comprising:
multilayer wiring circuits, each having a wiring metal and an interlayer insulating film; and
an amorphous carbon film interleaved between the wiring circuits,
wherein the amorphous carbon film contains hydrogen and carbon, is formed with an additive silicon and has a dielectric constant of about 3.3 or less.

4. The semiconductor device of claim 3, wherein the amorphous carbon film is used as a barrier film for preventing an element of a wiring metal in one wiring circuit from being diffused into an interlayer insulating film of an adjacent wiring circuit.

5. The semiconductor device of claim 3, wherein the amorphous carbon film is layered on the interlayer insulating film and used as a mask when forming a recess portion, in which a wiring metal is buried, in the interlayer insulating film.

6. A film forming method comprising:
mounting a substrate on a mounting table installed in a processing chamber; and
forming an insulating film including silicon-containing amorphous carbon on the substrate by plasma obtained by exciting a hydrocarbon gas having a multiple bond and a silicon-containing gas into plasma within the processing chamber.

7. The film forming method of claim 6, wherein the hydrocarbon gas is a butyne gas.

8. The film forming method of claim 6, wherein an internal pressure of the processing chamber is maintained in a range from about 5.33 Pa to about 9.33 Pa during formation of the insulating film.

9. A film forming apparatus comprising:
a processing chamber;
a mounting table installed in the processing chamber, for mounting a substrate;
a gas evacuation unit for evacuating an inside of the processing chamber;
a first gas supply unit for supplying a plasma generation gas to the inside of the processing chamber;
a second gas supply unit for supplying a hydrocarbon gas having a multiple bond and a silicon-containing gas to the inside of the processing chamber; and
a plasma generator for forming an insulating film including silicon-containing amorphous carbon on the substrate by plasma obtained by exciting the hydrocarbon gas and the silicon-containing gas into plasma within the processing chamber.

10. A storage medium storing a computer program for performing a film forming method on a computer, the film forming method comprising:
mounting a substrate on a mounting table installed within a processing chamber; and
forming an insulating film made of silicon-containing amorphous carbon on the substrate by plasma obtained by exciting a hydrocarbon gas having a multiple bond and a silicon-containing gas into plasma within the processing chamber.
